# EUROPEAN PATENT APPLICATION

(11) **EP 3 306 657 A1**
(43) Date of publication of application: **11.04.2018**
(21) Application number: 15894087.4
(22) Date of filing: 29.05.2015
(51) Int. Cl.: H01L 23/28, H01L 25/07, H01L 25/18, H02K 11/00

(54) **SEMICONDUCTOR DEVICE**

(71) Applicant: Shindengen Electric Manufacturing Co., Ltd., Tokyo 100-0004 (JP)
(72) Inventor: SASAKI Mitsumasa, Hanno-shi Saitama 357-8585 (JP)
(74) Representative: Dr. Weitzel & Partner
(86) International application number: PCT/JP2015/065589
(87) International publication number: WO 2016/194052

(57) **Abstract**

A semiconductor device includes: a device main body that is annular or partially annular, the device main body having an inner circumferential surface formed arcuate in plan view and an outer circumferential surface formed arcuate in plan view; a plurality of first leads that are strip-shaped, the plurality of first leads protruding from the inner circumferential surface and being arranged at intervals in a circumferential direction of the inner circumferential surface; and a plurality of second leads that are strip-shaped, the plurality of second leads protruding from the outer circumferential surface and being arranged at intervals in a circumferential direction of the outer circumferential surface. A dimension, in a width direction, of the second lead along the circumferential direction is larger than a dimension, in a width direction, of the first lead along the circumferential direction.

## Description

### TECHNICAL FIELD

The present invention relates to a semiconductor device.

### BACKGROUND ART

Semiconductor devices having such a configuration that a plurality of rectangular leads protrude from a device main body include a semiconductor device having plural types of leads with different width dimensions.

For example, Patent Document 1 discloses a semiconductor device including: a device main body having a rectangular shape in plan view; and a plurality of power supply leads and a plurality of signal leads which protrude from the device main body so as to be arranged at intervals in one direction. The signal leads along the above-described one direction (arrangement direction) is smaller in width dimension than the power supply leads along the arrangement direction.

### CITATION LIST

### [Patent Document]

[Patent Document 1] Japanese Patent Application Laid-Open Publication No. 2015-35565

### SUMMARY OF THE INVENTION

### [Problems to be Solved by the Invention]

However, the semiconductor device of Patent Document 1 has a problem that since the signal leads are smaller in width dimension than the power supply leads, only the signal leads are likely to deform when external force acts on the power supply leads and the signal leads.

For example, semiconductor devices are often transported in a state of being stored in a tray. For example, when the signal leads hit the tray due to vibration during the transportation, external force acts on the signal leads, and thus the signal leads are likely to deform.

One embodiment of the present invention has an object to provide a semiconductor device capable of suppressing deformation of leads caused by external force.

### [Means for Solving the Problems]

A semiconductor device according to one aspect of the present invention includes: a device main body that is annular or partially annular, the device main body having an inner circumferential surface formed arcuate in plan view and an outer circumferential surface formed arcuate in plan view; a plurality of first leads that are strip-shaped, the plurality of first leads protruding from the inner circumferential surface and being arranged at intervals in a circumferential direction of the inner circumferential surface; and a plurality of second leads that are strip-shaped, the plurality of second leads protruding from the outer circumferential surface and being arranged at intervals in a circumferential direction of the outer circumferential surface. A dimension, in a width direction, of the second lead along the circumferential direction is larger than a dimension, in a width direction, of the first lead along the circumferential direction.

### [Effects of the Invention]

According to one embodiment of the present invention, the first leads with the small width dimension are provided on the inner circumferential surface of the device main body formed in an annular or partially-annular shape in plan view. In other words, the first leads are surrounded by the device main body. Therefore, it is possible to suppress external force from acting on the first leads during transportation or the like of the semiconductor device. In other words, deformation of the first leads can be suppressed.

On the other hand, since the second leads larger in dimension in the width direction than the first leads are provided on the outer circumferential surface of the device main body. Therefore, deformation of the second leads can be suppressed even if external force acts on the second leads.

### BRIEF DESCRIPTION OF THE DRAWINGS

FIG. 1 is a schematic perspective view showing a configuration of a semiconductor device according to a first embodiment of the present invention.
FIG. 2 is a view seen from A shown in FIG. 1.
FIG. 3 is a view seen from B shown in FIG. 2.
FIG. 4 is a schematic perspective view showing a configuration of a modified example of the semiconductor device according to the first embodiment of the present invention.
FIG. 5 is a cross-sectional view taken along a line C-C shown in FIG. 4.
FIG. 6 is a cross-sectional view taken along a line D-D shown in FIG. 4;
FIG. 7 is a schematic perspective view showing a configuration of a semiconductor device according to a second embodiment of the present invention.
FIG. 8 is a view seen from E shown in FIG. 7.
FIG. 9 is a view seen from F shown in FIG. 8.

### MODE FOR CARRYING OUT THE INVENTION

Embodiments of the present invention will be described below with reference to the accompanying drawings. In all the drawings, the same or corresponding members are appended with the same reference numerals even between different embodiments, and common description is omitted.

### [First Embodiment]

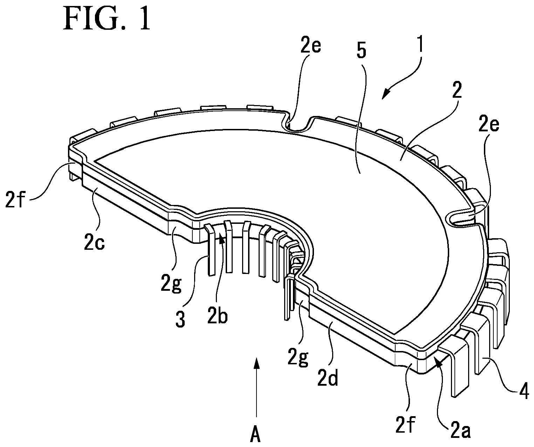

A semiconductor device according to a first embodiment of the present invention will be described with reference to FIGS. 1 to 3.

As shown in FIG. 1, a semiconductor device 1 of the present embodiment includes a device main body 2, a heat dissipation unit 5, first leads 3, and second leads 4.

The device main body 2 is one formed by sealing a circuit including a semiconductor element and the like (not shown) with a sealing material, and is formed in a plate shape with a predetermined thickness.

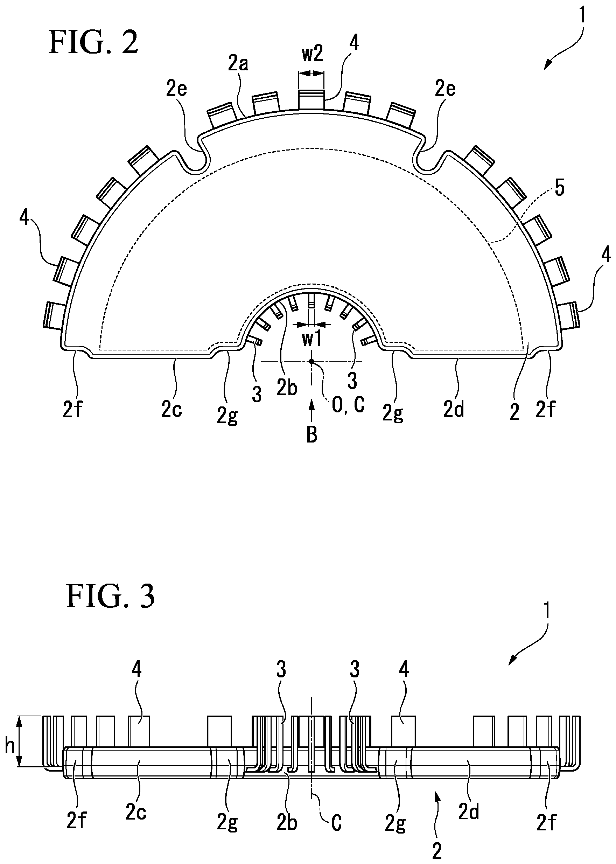

As shown in FIG. 2, a schematic shape, in plan view, of the device main body 2 is semicircular annular (partially annular) with the center at a point O.

The device main body 2 includes an outer circumferential surface 2a, an inner circumferential surface 2b, a first side surface 2c, and a second side surface 2d, as side surfaces extending in the plate thickness direction.

As shown in FIG. 3, in side view, the device main body 2 has a plate shape with a constant thickness.

As shown in FIG. 2, the outer circumferential surface 2a is a side surface extending circular-arcuately around the point O in plan view. For example, the shape of the outer circumferential surface 2a may be a shape such that a middle portion in the plate thickness direction bulges, as shown in FIG. 3.

As shown in FIG. 2, the inner circumferential surface 2b is a side surface extending circular-arcuately around the point O in plan view. The inner circumferential surface 2b is smaller in radius than the outer circumferential surface 2a. The outer circumferential surface 2a and the inner circumferential surface 2b are formed circular arcuate (arcuate) and concentric to each other. For example, the shape of the inner circumferential surface 2b may be a shape such that a middle portion in the plate thickness direction bulges, as shown in FIG. 3.

Hereinafter, in the semiconductor device 1, in describing a relative position with respect to the device main body 2, a direction going around a central axis C of the outer circumferential surface 2a and the inner circumferential surface 2b will be referred to as a circumferential direction, while a direction along lines all intersecting at the central axis C in a virtual plane orthogonal to the central axis C will be referred to as a radial direction. The central axis C passes through the point O and is an axis extending in the plate thickness direction of the device main body 2. The direction along the central axis C is the plate thickness direction of the device main body 2.

In the radial direction, a side away from the central axis C will be occasionally referred to as a radially outward, while a side toward the central axis C will be occasionally referred to as a radially inward.

The first side surface 2c and the second side surface 2d are side surfaces formed at both end portions, in the circumferential direction, of the device main body 2. In the present embodiment, since the device main body 2 is semicircular annular, the first side surface 2c and the second side surface 2d are side surfaces both extending along the same imaginary straight line passing through the point O in plan view.

Between the first side face 2c and the second side face 2d, the inner circumferential surface 2b is positioned. Therefore, in plan view, the inner circumferential surface 2b constitutes a semicircular concave groove portion that recesses inward from the first side surface 2c and the second side surface 2d of the device main body 2.

First grooves 2e, which are U-shaped in plan view and recessed inward from the outer circumferential surface 2a of the device main body 2 (direction toward the point O), penetrate through the outer circumferential surface 2a in the plate thickness direction of the device main body 2.

Each of the first groove portions 2e can be used as an insertion hole through which a screw is inserted when the semiconductor device 1 is screwed.

The number and formed position of first groove portions 2e are not particularly limited. In the present embodiment, as an example, the first groove portions 2e are formed at two points which equally divide the outer circumferential surface 2a in the circumferential direction.

Second groove portions 2f penetrating in the plate thickness direction are formed at corner portions of the device main body 2, which are defined by the outer circumferential surface 2a and the first side surface 2c (second side surface 2d). The second groove portion 2f is formed in a J-shape having a straight line portion parallel to the first side surface 2c (second side surface 2d) in plan view and a curved portion approaching the first side surface 2c (second side surface 2d) toward the point O.

Third groove portions 2g penetrating in the plate thickness direction are formed at corner portions of the device main body 2, which are defined by the inner circumferential surface 2b and the first side surface 2c (second side surface 2d). The third groove portion 2g is formed in a J-shape having a straight line portion parallel to the first side surface 2c (second side surface 2d) in plan view and a curved portion approaching the first side surface 2c (second side surface 2d) toward the point O.

When two semiconductor devices 1 are arranged in such a positional relationship that the first side surface 2c and the second side surface 2d face each other, the second groove portion 2f (third groove portion 2g) forms a U-shaped concave groove portion that recesses radially inward from the outer circumferential surface 2a (inner circumferential surface 2b).

Therefore, the second groove portion 2f and the third groove portion 2g can be used as insertion holes through which screws are inserted when the two semiconductor devices 1 arranged as described above are screwed.

As a material of the device main body 2, it is possible to adopt all the same materials as materials used for packages of conventional semiconductor devices. For example, the device main body 2 may be made of a sealing resin.

The heat dissipation unit 5 is provided on a surface of the device main body 2 in order to improve heat dissipation property of the device main body 2. The heat dissipation unit 5 is thermally-conductively joined to a heat generation unit including a semiconductor element and the like of a circuit (not shown) in the device main body 2.

As a material of the heat dissipation unit 5, for example, metal with high thermal conductivity, such as copper, aluminum or the like, can be used.

The first leads 3 and the second leads 4 are leads for connecting the semiconductor device 1 to a circuit board or an apparatus (not shown). The plurality of first leads 3 and the plurality of second leads 4 protrude outward from the side surfaces of the device main body 2.

At least a part of the plurality of first leads 3 and at least a part of the plurality of second leads 4 are electrically connected to a semiconductor element (not shown) in the device main body 2.

The plurality of first leads 3 protrude radially inward from the inner circumferential surface 2b of the side surfaces of the device main body 2 and are arranged at intervals in the circumferential direction of the inner circumferential surface 2b. The arrangement intervals of the plurality of first leads 3 may be constant or may not be constant. In the present embodiment, as an example, the plurality of first leads 3 are arranged at regular intervals equally dividing the inner circumferential surface 2b in the circumferential direction.

The first leads 3 are made of a strip-shaped metal.

"Strip-shape" includes a "band plate shape" and a "rod shape." In the case of the rod shape, a cross-sectional shape of the rod is not particularly limited, and may be, for example, a circle, an ellipse, or a polygon.

In the present embodiment, as an example, the first lead 3 is formed in a rectangular rod shape whose plate width direction is along the circumferential direction of the inner circumferential surface 2b. The plate width of the first lead 3 is w1. Therefore, the dimension, in the width direction, of the first lead 3 along the circumferential direction of the inner circumferential surface 2b is also w1.

The protruding direction and the protrusion shape of the first leads 3 (shape viewed from the direction crossing the protruding direction) are not particularly limited. In the present embodiment, as an example, the first lead 3 is formed in an L-shape by extending from a base end portion in the protruding direction toward the point O, while being bent in the middle portion in the protruding direction so that the front end portion of the first lead 3 substantially faces the plate thickness direction of the device main body 2 (including the case of the thickness direction). By the first lead 3 being bent in this manner, interference among the first leads 3 can be avoided even if the first leads 3 are long in length. Therefore, the arrangement intervals, in the circumferential direction, of the first leads 3 can be reduced, and the number of first leads 3 on the inner circumferential surface 2b can be easily increased.

In the thickness direction of the device main body 2, the protruding directions of the front end portions of the first leads 3 are opposite to the side where the heat dissipation unit 5 is provided. The protrusion shape of the first lead 3 is a rectangular shape with a width w1 when viewed from the radial direction.

The number of first leads 3 is not particularly limited as long as it is 2 or more.

The plurality of second leads 4 protrude radially outward from the outer circumferential surface 2a of the side surfaces of the device main body 2 and are arranged at intervals in the circumferential direction of the outer circumferential surface 2a. The arrangement intervals of the plurality of second leads 4 may be constant or may not be constant. In the present embodiment, as an example, the same number of second leads 4 are arranged at equal pitches in each of three regions divided by the first groove portions 2e.

The second leads 4 are made of a strip-shaped metal. A material of the second lead 4 may be different from that of the first lead 3. In the present embodiment, as an example, the material of the second lead 4 is the same as that of the first lead 3.

In the present embodiment, as an example, the second lead 4 is formed in a band plate shape whose plate width direction is along the circumferential direction of the outer circumferential surface 2a. The plate width of the second lead 4 is w2 (where w2>w1). Therefore, the dimension of the second lead 4 in the width direction along the circumferential direction of the outer circumferential surface 2a is also w2.

A plate thickness of the second lead 4 is equal to the plate thickness of the first lead 3.

In the present embodiment, the second lead 4 is formed in an L-shape similar to that of the first lead 3. A bending direction of a middle portion, in the protruding direction, of the second lead 4 is the same as that of the first lead 3. Since the bending directions of the first lead 3 and the second lead 4 (direction of the front end portion of the second lead 4) are the same, the first lead 3 and the second lead 4 can be connected on the same substrate.

The protrusion shape of the second lead 4 (the length in the radial direction of the device main body 2 and the length in the plate thickness direction thereof) may be the same as, or different from, that of the first lead 3.

The number of second leads 4 is not particularly limited as long as it is 2 or more.

By such a configuration, the second leads 4 of the present embodiment have high rigidity and high strength as compared with the first leads 3.

In the present embodiment, since the first leads 3 and the second leads 4 have the same material and plate thickness, the first leads 3 and the second leads 4 can be manufactured from a single lead frame.

Since the first lead 3 is smaller in plate width than the second lead 4, the first lead 3 has the higher electrical resistance than that of the second lead 4. Therefore, the first lead 3 may be used as, for example, a signal lead.

Since the second lead 4 is larger in plate width than the first lead 3, the second lead 4 has the lower electrical resistance than that of the first lead 3. Therefore, the second lead 4 may be used as, for example, a power supply lead.

Operation of the semiconductor device 1 of the present embodiment will be described.

According to the semiconductor device 1, the semiconductor device 1 includes the first leads 3 and the second leads 4, and the first lead 3 has the lower rigidity and lower strength than those of the second lead 4.

Therefore, when external force is applied, the first lead 3 is more likely to deform than the second lead 4.

In the present embodiment, all the first leads 3 protrude outward from the inner circumferential surface 2b constituting the concave groove portion with respect to the first side surface 2c and the second side surface 2d.

In other words, the inner circumferential surface 2b is recessed inward from the first side surface 2c and the second side surface 2d. Therefore, the first leads 3 are surrounded by the device main body 2. Thereby, it is possible to suppress the external force from acting on the first leads 3 during transportation or the like of the semiconductor device 1. In other words, deformation of the first lead 3 can be suppressed.

On the other hand, since the outer circumferential surface 2a of the semiconductor device 1 is a convex side surface, the outer circumferential surface 2a is likely to get in contact with another member during transportation or the like and thus is easily subject to external force. In the present embodiment, however, it is the second lead 4 with the higher rigidity and higher strength than those of the first lead 3 that protrudes from the outer circumferential surface 2a.

Therefore, even if the second lead 4 receives external force, deformation of the second lead 4 is suppressed.

As described above, according to the semiconductor device 1 of the present embodiment, deformation of the first leads 3 and the second leads 4 due to external force can be suppressed.

Additionally, since the semiconductor device 1 of the present embodiment has the semicircular annular shape in plan view, the semiconductor device 1 can be attached onto an apparatus such as a motor having a circular attaching surface, thereby making it possible to achieve space saving and miniaturization.

Since the semiconductor device 1 is semicircular annular in plan view, the two semiconductor devices 1 having the same shape are arranged and attached onto an apparatus such that the first side face 2c and the second side face 2d face each other, so as to form a circular annular shape as a whole.

For example, when the semiconductor device 1 is attached onto a circular or circular-annular attaching surface of a cylindrical motor, the diameter of the circumference on which the second leads 4 of the semiconductor device 1 are arranged is set to be equal to or smaller than the outer diameter of the motor, thereby making it possible to prevent the semiconductor device 1 from protruding radially outward from the motor. In this case, the outer diameter of a motor module including the semiconductor device 1 is equal to the outer diameter of the motor, so that the motor module can be formed into a simple cylindrical shape. Therefore, it becomes easy to attach the motor module onto another apparatus.

### [Modified Example]

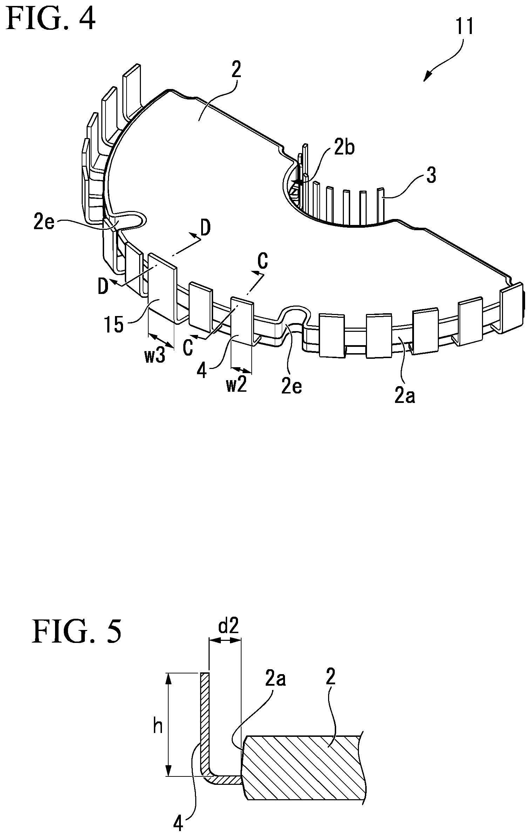

A semiconductor device according to a modified example of the first embodiment of the present invention will be described with reference to FIGS. 4 to 6.

As shown in FIG. 4, a semiconductor device 11 of the present modified example is configured such that part of the plurality of second leads 4 of the above-described first embodiment is replaced with a gripping lead 15. FIG. 4 shows a case where there is one gripping lead 15 as an example, but the number of gripping leads 15 may be two or more.

Hereinafter, differences from the first embodiment will be mainly described.

Similar to the second lead 4, the gripping lead 15 protrudes outward from the outer circumferential surface 2a. Similar to the second lead 4, the dimension, in the width direction, of the gripping lead 15 along the circumferential direction of the outer circumferential surface 2a is larger than the dimension, in the width direction, of the first lead 3.

However, the shape of the gripping lead 15 is different from that of the second lead 4.

The gripping lead 15 is provided to grip the semiconductor device 11.

Therefore, the rigidity and strength of the gripping lead 15 are set to such rigidity and strength that the gripping leads 15 are not plastically deformed or broken even when the semiconductor device 11 is gripped at the gripping lead 15.

Further, the gripping lead 15 may not be electrically connected to a semiconductor element (not shown). Therefore, a material of the gripping lead 15 may be metal or non-metal.

In the present modified example, as an example, the gripping lead 15 is the same metal as the first lead 3 and the second lead 4.

The shape of the gripping lead 15 is not particularly limited as long as it is a grippable shape and is easily recognized as being different from the shape of the second lead 4. Here, "grippable" means that it has a grippable size and does not plastically deform due to its own weight even when gripped.

For example, the shape of the gripping lead 15 may be a band plate shape, and may have a shape with a plate width different from that of the second lead 4.

For example, the shape of the gripping lead 15 may be a band plate shape, and may have a shape with a plate width different from that of the second lead 4.

For example, the shape of the gripping lead 15 may be different from that of the second lead 4 when viewed from the radial direction or the plate thickness direction of the device main body 2. For example, the shape of the gripping lead 15 may be such that the plate width varies along the protruding direction.

In the present embodiment, as an example, the shape of the gripping lead 15 is such that the plate thickness thereof is the same as the plate thickness of the second lead 4, and the plate width and the protruding shape thereof is different from those of the second lead 4.

As shown in FIG. 4, similar to the second lead 4, the gripping lead 15 of the present modified example is formed in a band plate shape with the plate width that is along the circumferential direction of the outer circumferential surface 2a. However, the plate width of the gripping lead 15 is w3 (where w3>w2) and is different from the plate width of the second lead 4.

As shown in FIG. 5, the protrusion shape of the second lead 4 of the present modified example is an L-shape such that it is bent at a position where it protrudes by a distance d2 from the outer circumferential surface 2a, while a length from the bent portion (middle portion in the protruding direction from the outer circumferential surface) to the front end portion is h.

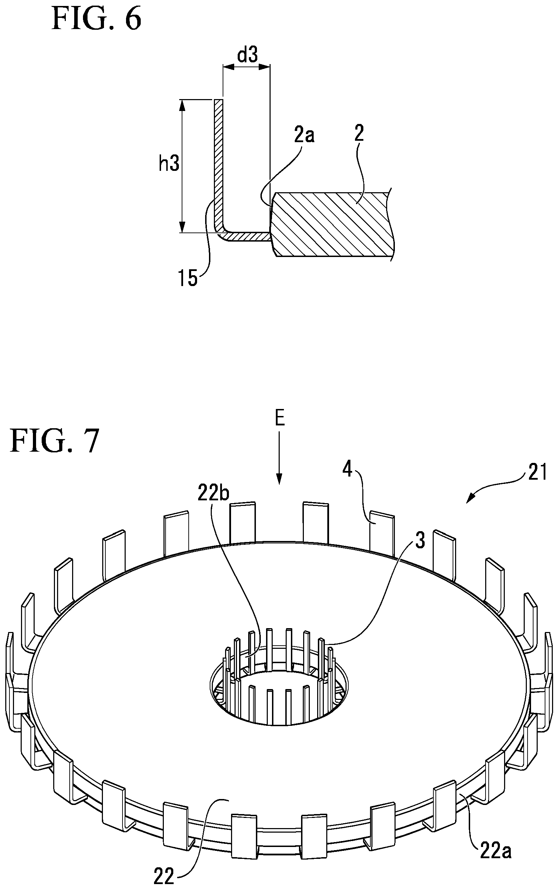

On the other hand, as shown in FIG. 6, the protrusion shape of the gripping lead 15 of the present modified example is such that it is bent at a position where it protrudes by a distance d3 (where d3>d2) from the outer circumferential surface 2a, in the same direction as the extending direction of the second lead 4, and a length from this bent portion (middle portion in the protruding direction from the outer circumferential surface) to the front end portion is h3 (where h3>h).

By such a configuration, the gripping lead 15 of the present modified example protrudes radially outward from, in the plate thickness direction of, the device main body 2 further than the second lead 4. Therefore, the gripping lead 15 has a shape easily distinguishable from that of the second lead 4.

In the present modified example, the gripping lead 15, the first lead 3, and the second lead 4 can be manufactured from a single lead frame.

Operation of the semiconductor device 11 of the present modified example will be described.

Since the semiconductor device 11 includes the device main body 2 having the same shape as that of the first embodiment, the first leads 3, and the second leads 4, the semiconductor device 11 has the same action as that of the first embodiment.

Therefore, according to the semiconductor device 11, it is possible to suppress deformation of the first leads 3 and the second leads 4 due to external force, as in the first embodiment.

Additionally, according to the semiconductor device 11, for example, the semiconductor device 11 can be attached onto an apparatus such as a motor having a circular attaching surface, thereby making it possible to achieve space saving and miniaturization.

For example, when the semiconductor device 11 is attached onto a circular or circular-annular attaching surface of a cylindrical motor, the diameter of the circumference on which the second leads 4 and the gripping lead 15 of the semiconductor device 11 are arranged is set to be equal to or smaller than the outer diameter of the motor, thereby making it possible to prevent the semiconductor device 11 from protruding radially outward from the motor. In this case, the outer diameter of a motor module including the semiconductor device 11 is equal to the outer diameter of the motor, so that the motor module can be formed into a simple cylindrical shape. Therefore, it becomes easy to attach the motor module onto another apparatus.

Further, since the semiconductor device 11 of the present modified example includes the gripping lead 15, it is possible to transport the semiconductor device 11 by gripping the gripping lead 15 without touching the second leads 4 and the first leads 3.

### [Second Embodiment]

A semiconductor device according to a second embodiment of the present invention will be described with reference to FIGS. 7 to 9.

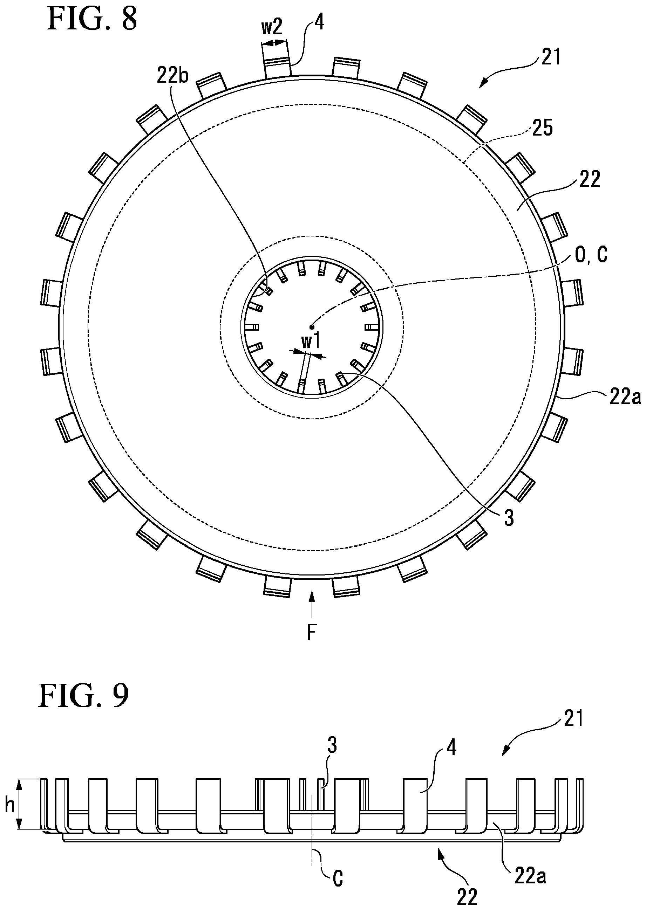

As shown in FIGS. 7 and 8, a semiconductor device 21 of the present embodiment includes a device main body 22 and a heat dissipation unit 25 (see FIG. 8), in place of the device main body 2 and the heat dissipation unit 5 of the above-described first embodiment.

Hereinafter, differences from the first embodiment will be mainly described.

The device main body 22 is one formed by sealing a circuit including a semiconductor element and the like (not shown) with a sealing material, and is formed in a plate shape with a predetermined thickness.

As shown in FIG. 8, a schematic shape, in plan view, of the device main body 22 is circular annular (annular) with the center at a point O.

The device main body 22 includes an outer circumferential surface 22a and an inner circumferential surface 22b as side surfaces extending in the plate thickness direction.

As shown in FIG. 9, in side view, the device main body 22 has a plate shape with a constant thickness.

The outer circumferential surface 22a and the inner circumferential surface 22b are the same side surfaces as the outer circumferential surface 2a and the inner circumferential surface 2b of the first embodiment, except that the outer circumferential surface 22a and the inner circumferential surface 22b are formed concentric around the point O as a center.

Similarly to the first embodiment, also in the description of the present embodiment, the circumferential direction, the radial direction, and the like are occasionally used with respect to the central axis C of the outer circumferential surface 22a and the inner circumferential surface 22b, which passes through the point O.

A first groove portion 2e similar to that of the above-described first embodiment may be formed in the outer circumferential surface 22a and the inner circumferential surface 22b.

A material of the device main body 22 may be the same material as that of the device main body 2 in the above-described first embodiment.

A plurality of first leads 3 having the same configuration as that of the above-described first embodiment protrude outward from the inner circumferential surface 22b of the device main body 22. The number and arrangement pitch of the first leads 3 are not particularly limited.

A plurality of second leads 4 having the same configuration as that of the above-described first embodiment protrude outward from the outer circumferential surface 22a of the device main body 22. The number and arrangement pitch of the second leads 4 are not particularly limited.

As shown in FIG. 8, the heat dissipation unit 25 is the same member as the heat dissipation unit 5 of the above-described first embodiment, except that the heat dissipation unit 25 is formed in a circular annular shape in plan view corresponding to the circular annular shape, in plan view, of the device main body 22.

The semiconductor device 21 having such a configuration is the same as the semiconductor device 1 of the above-described first embodiment except that the device main body 22 is circular annular.

Regarding the second leads 4 protruding from the outer circumferential surface 22a, deformation of the second leads 4 due to external force can be suppressed for the same reason as in the above-described first embodiment.

Regarding the first leads 3 protruding from the inner circumferential surface 22b, in the present embodiment, the first leads 3 are surrounded by the device main body 22 over the entire circumference. Therefore, as compared with the case where the first leads 3 are arranged on the concave groove portion of the above-described first embodiment, deformation of the first leads 3 due to external force can more reliably be suppressed.

Here, the description has been given in the above first and second embodiments with respect to the cases where the device main body 2 is semicircular annular in plan view, and the device main body 22 is annular in plan view. However, in order to arrange the first leads 3, it is sufficient that a concave groove portion defined by the inner circumferential surface or a hole portion surrounded by the inner circumferential surface is formed in the device main body. In other words, it is not essential that the concave groove portion and the hole portion defined by the inner circumferential surface are semicircular and circular, respectively.

For example, the inner circumferential surface may form a polygonal concave groove portion or an elliptical concave groove portion. Further, the inner circumferential surface may form a polygonal hole portion or an elliptical hole portion.

The description has been given in each of the above-described embodiments and the modified example with respect to the cases where the device main body 2 is semicircular annular in plan view, and the device main body 22 is circular annular in plan view. However, it is sufficient that the device main body has an annular or partially annular shape in plan view. Therefore, the shape, in plan view, of the device main body is not limited to the circular annular or semicircular annular shape.

For example, the shape, in plan view, of the device main body may be any of an elliptical annular shape, a polygonal annular shape, and an annular shape with a radial width that is non-uniform in the circumferential direction. For example, in a case where an outer shape of a motor to be attached with the semiconductor device has a polygonal outer shape, a shape of the outer circumferential surface of the device main body may be an annular or partially-annular outer shape having a polygonal outer circumferential surface corresponding to the outer shape of the motor. In this case, the shape, in plan view, of the inner circumferential surface of the device body may be, for example, a polygonal shape, a circular shape, an elliptical shape, or the like.

If the device main body has an outer shape other than a circular annular shape or semicircular annular shape, the description in the above embodiments and the above modified examples may be read by replacing the axial direction, the circumferential direction, and the radial direction with the directions relating to the entire outer shape or part of an approximate circle (circular arc), and its central axis.

The partially annular shape is not particularly limited as long as an inner circumferential surface forms a concave groove shape as an outer shape of the device main body. Therefore, even a center angle representing a range of the inner circumferential surface with respect to the center of the partially annular shape is not particularly limited. For example, the central angle is not limited to 180° as of the semicircular annular shape, and may be smaller or larger than 180°. However, the central angle is preferably large to more reliably suppress the deformation of the first leads 3.

The description has been given in each of the above-described embodiments and the modified example with respect to the case where the device main body 2 is semicircular annular in plan view, the device main body 22 is circular annular in plan view, and the inner circumferential surface 2b (22b) and the outer circumferential surface 2a (22a) are concentric to each other.

However, the inner circumferential surface and the outer circumferential surface may be, for example, eccentric to each other. In a case where the device main body is partially annular, and the inner circumferential surface and the outer circumferential surface are eccentric to each other, by using two semiconductor devices having shapes that are mutually plane-symmetric in plan view, the two semiconductor devices can be attached onto an apparatus so as to form an annular shape as a whole.

Although it has been described in each of the above-described embodiments and the modified example that the semiconductor device may be attached onto a motor, each semiconductor device may be attached onto an apparatus other than the motor.

Although the preferred embodiments of the present invention have been described above, the present invention is not limited to these embodiments and modified example thereof. Additions, omissions, substitutions, and other changes of configurations may be made without departing from the spirit of the present invention.

Additionally, the present invention is not limited to the above description, but is limited only by the attached claims.

### DESCRIPTION OF REFERENCE NUMERALS

- 1, 11,21: semiconductor device
- 2: device main body
- 2a, 22a: outer circumferential surface
- 2b, 22b: inner circumferential surface
- 3: first lead
- 4: second lead
- 15: gripping lead

## Claims

1. A semiconductor device comprising:
a device main body that is annular or partially annular, the device main body having an inner circumferential surface formed arcuate in plan view and an outer circumferential surface formed arcuate in plan view;
a plurality of first leads that are strip-shaped, the plurality of first leads protruding from the inner circumferential surface and being arranged at intervals in a circumferential direction of the inner circumferential surface; and
a plurality of second leads that are strip-shaped, the plurality of second leads protruding from the outer circumferential surface and being arranged at intervals in a circumferential direction of the outer circumferential surface,
wherein a dimension, in a width direction, of the second lead along the circumferential direction is larger than a dimension, in a width direction, of the first lead along the circumferential direction.

2. The semiconductor device according to claim 1, further comprising:
a gripping lead provided so as to protrude from the outer circumferential surface, the gripping lead having a different shape than that of the second lead, and the gripping lead having a dimension in a width direction that is larger than the dimension, in the width direction, of the first lead.

3. The semiconductor device according to claim 2, wherein
the gripping lead protrudes from the outer circumferential surface further than the second lead in a protruding direction.

4. The semiconductor device according to claim 2 or 3, wherein
the gripping lead and the second lead are bent in middle portions thereof in the protruding direction from the outer circumferential surface and extend up to front end portions thereof, and
a length of the gripping lead from the middle portion to the front end portion thereof is larger than a length of the second lead from the middle portion to the front end portion thereof.

5. The semiconductor device according to any one of claims 1 to 4, wherein
the first lead is bent in a middle portion thereof in the protruding direction from the outer circumferential surface, and
a front end side of the first lead extends from the middle portion in a direction intersecting the protruding direction.
